# EUROPEAN PATENT APPLICATION

(11) **EP 4 575 645 A1**
(43) Date of publication of application: **25.06.2025**
(21) Application number: 23218877.1
(22) Date of filing: 20.12.2023
(51) Int. Cl.: G03F 7/20, G01N 23/20058, H01J 37/29, H01J 37/295

(54) **LEED AND PTYCHOGRAPHY BASED SURFACE PROFILE DETERMINATION**

(71) Applicant: ASML Netherlands B.V., 5500 AH Veldhoven (NL)
(72) Inventor: COENE, Willem, Marie, Julia, Marcel, 5500 AH Veldhoven (NL); VAN RENS, Jasper, Frans, Mathijs, 5500 AH Veldhoven (NL); KRECINIC, Faruk, 5500 AH Veldhoven (NL); GARMING, Mathijs, Wouter, Henk, 5500 AH Veldhoven (NL); KOOIMAN, Marleen, 5500 AH Veldhoven (NL)
(74) Representative: ASML Netherlands B.V.

(57) **Abstract**

In low-energy-electron diffraction (LEED), electron diffraction patterns are measured, and no projection or imaging lenses are present to form an image of a sample surface. Instead, an image may be formed based on a series of electron diffraction patterns from electrons reflected and diffracted from the sample surface. A LEED diffraction pattern out of this series of diffraction patterns can be generated from the interaction of a relatively localized coherent electron beam incident on the sample surface. Phase information from the diffraction pattern can be used to determine (or reconstruct) structures on the sample surface. Advantageously, LEED is used in combination with ptychography (to generate a series of diffraction patterns which are each associated with a given particle beam position, where particle beams centered at neighboring positions are partially overlapping) to determine semiconductor wafer surface structures through lensless imaging for defect inspection and/or other purposes.

## Description

### TECHNICAL FIELD

The present disclosure relates generally to systems and methods for low-energy-electron diffraction (LEED) with a low-energy-electron diffractometer and ptychography based surface profile determination.

### BACKGROUND

In manufacturing processes of integrated circuits (ICs), unfinished or finished circuit components are inspected to ensure that they are manufactured according to design and are free of defects. Inspection systems utilizing optical microscopes or charged particle (e.g., electron) beam microscopes, such as a scanning electron microscope (SEM) and low-energy electron microscopy (LEEM) may be employed. As the physical sizes of IC components continue to shrink, and their structures continue to become more complex, accuracy and throughput in defect detection and inspection become more important. Imaging of complex structures such as high-aspect-ratio trenches or holes of 3D NAND devices, thick resists which may have low contrast, etc. may require imaging of 3D features which have projections in the electron beam direction which are larger than the depth of focus of a traditional scanning electron microscope (SEM) and which may have structures (such as resist layers) which may experience deterioration from high-energy electrons. For applications such as overlay metrology, defect inspection (including resist inspection, etch inspection), etc., it may be desirable to obtain high-quality, non-destructive imaging with information about surface profiles from reflected electrons.

In the context of semiconductor manufacture, wafers need to be monitored and defects identified, preferably at stages where they may be corrected. Various solutions for imaging have been proposed.

### SUMMARY

In low-energy-electron diffraction, no projection lenses are needed to form a diffraction pattern associated with a sample surface. Using ptychography, an image may be formed computationally based on electron diffraction patterns from electrons reflected and diffracted from the sample surface. A low energy electron diffraction (LEED) pattern can be generated from the interaction of a relatively localized coherent electron beam incident on the sample surface. LEEM and LEED are operated with a coherent electron beam, that can be focused into a coherent electron probe, which is localized on the sample surface. Coherence or (limited) partial coherence is a prerequisite in order to be able to apply ptychography. The size of the coherent electron probe can itself be much larger than a desired resolution, where a factor of 10x to 100x is not unusual.

Advantageously, LEED is used in combination with ptychography (to generate a series of diffraction patterns which are each associated with a given particle beam position, where particle beams centered at neighboring positions are partially overlapping) to determine semiconductor wafer surface structures through lensless imaging for defect inspection and/or other purposes. Using ptychography, phase information can also be reconstructed from the diffraction patterns, which includes valuable information related to the height/depth profile of the sample surface. This can be exploited to detect scum defects in semiconductor wafer structures, as one example application. In addition, with the phase retrieved in addition to a measured amplitude in the diffraction space (or Fourier space, reciprocal space, or spatial frequency space), the full complex-valued field is available for use, and by applying a two dimensional (2D) Fourier transform on this 2D complex-valued field, the field in real space can be obtained, where the amplitude or amplitude squared of this real space field yields a computationally generated image intensity (or its square root).

According to an embodiment, there is provided a metrology system. The metrology system comprises a particle beam generator configured to generate a coherent or partially coherent particle beam having a beam energy and beam size. In some embodiments, the system comprises an energy reducer configured to reduce the beam energy. (In some embodiments, the particle beam may already have the reduced energy, or the energy of the particle beam may be reduced using some other method.) A reduced energy beam is configured to be reflected and diffracted by a sample surface. The system comprises detector configured to detect intensity information from coherently reflected and diffracted particle beams and their associated wavefronts from the sample surface, for a reflected coherent diffraction pattern. The system comprises one or more processors configured by machine-readable instructions. The one or more processors are configured to determine the diffraction pattern for an area of the sample surface corresponding to the beam size based on detected reflected and diffracted particle beams; aggregate the diffraction pattern with one or more of a series of diffraction patterns corresponding to different areas of the sample surface; and determine one or more structures on the sample surface based on the aggregating.

In some embodiments, diffraction patterns in the series of diffractions patterns are each associated with a given particle beam position. Particle beams centered at neighboring positions are partially overlapping. In some embodiments, the particle beam generator comprises a scanner configured such that the sample surface is scanned with the particle beam through different probing particle beam positions to generate the series of diffraction patterns, which are sequential in time, and correspond to different but neighboring areas of the sample surface. In some embodiments, scanning is performed either with a sample stage or with electron-optical deflectors of the metrology system.

In some embodiments, the particle beam generator, the energy reducer, the detector, and the one or more processors comprise a low-energy-electron diffractometer which is configured for measuring electron diffraction patterns.

In some embodiments, determining the diffraction pattern for the area of the sample surface; aggregating the diffraction pattern with one or more of the series of diffraction patterns; and determining the one or more structures on the sample surface based on the aggregating comprise ptychography operations.

In some embodiments, the particle beam generator, the energy reducer, the detector, and the one or more processors comprise a modified scanning electron microscope (SEM). The modified SEM has a low landing energy, a relatively localized coherent or partially coherent electron probe, a relatively localized coherent or partially coherent electron probe, a relatively localized coherent or partially coherent electron probe, projective optics configured to project a diffraction pattern on the detector, an energy filter configured to select elastically scattered electrons, and a pixelated detector configured to record a diffraction image.

In some embodiments, the particle beam is an electron beam and particles are electrons; the particle beam is a proton beam and the particles are protons; or the particle beam is a helium (He) beam, and the particles are He-ions. In some embodiments, the particle beam is a coherent electron beam. In some embodiments, the reflected and diffracted particle beams comprise a (can be interpreted in terms of a coherent) electron wavefront.

In some embodiments, the diffraction pattern and the one or more of the series of diffraction patterns are far field, or Fraunhofer, diffraction patterns.

In some embodiments, the one or more processors are configured to determine phase(s) and/or amplitude(s) of a particle wavefront that is associated with reflected and diffracted particle beams from the sample surface based on the diffraction pattern with the one or more of the series of diffraction patterns, and determine the one or more structures on the sample surface at least partially based on determined phase(s) and/or amplitude(s).

In some embodiments, the energy reducer is configured to cause the particle beam to have a specific (reduced) beam energy by reducing an initial energy of an initial particle beam from the particle beam generator to the specific (reduced) beam energy. In some embodiments, the (reduced energy) particle beam is a low-energy electron beam when reflected and diffracted by the sample surface. In some embodiments, the (reduced energy) particle beam has a reduced depth of interaction with the sample surface compared to that of the particle beam with the initial column and/or beam energy. In some embodiments, the energy reducer is configured to reduce the beam energy so that the (reduced energy) particle beam has an energy less than approximately 100 eV.

In some embodiments, the energy reducer is configured such that there is a potential difference, thus retarding an electric field, between the sample surface and an electron optical element, and wherein the particle beam is decelerated by biasing the sample surface at an appropriate potential with respect to an electron source potential. In some embodiments, the electron optical element comprises a probe forming lens generating a relatively localized coherent particle beam that illuminates the sample surface and/or an aperture, for example.

In some embodiments, reducing the beam energy causes the reduced energy beam to be reflected and diffracted by electric and/or magnetic fields at the sample surface, before direct interaction with the sample surface. In some embodiments, the reduced energy beam is elastically scattered by the sample surface.

In some embodiments, the system comprises a magnetic prism configured to change a direction of the particle beam toward the sample surface and change an opposite direction of reflected electrons towards the detector, one or more deflectors configured to be used to select sample surface locations from which diffraction patterns are obtained, and/or an aperture and/or lens configured to be used to adjust a particle beam diameter.

In some embodiments, the detector is a pixelated particle detector. The pixelated particle detector may be positioned at a given distance from the sample surface. The given distance may be determined based on a targeted detection numerical aperture (NA) and an associated resolution.

In some embodiments, the one or more structures on the sample surface comprise one or more structures in an integrated circuit formed in a semiconductor wafer. In some embodiments, the one or more structures on the sample surface comprise a contact hole, a pillar, a line/space pattern, a slot, a trench, and/or open space.

In some embodiments, determining the one or more structures comprises a measurement action referred to as defect inspection. In some embodiments, determining the one or more structures comprises reconstructing three dimensional (3D) information about the sample, which can for example be a depth profile of the sample surface based on a determined phase and/or amplitude of an electron waveform (or wavefront) of reflected and diffracted electrons. In some embodiments, determining the one or more structures comprises identifying defects in a depth profile of the sample surface.

In some embodiments, the one or more processors are configured to detect nanoscale electric fields associated with the sample surface based on variation in diffraction patterns caused by changes in a propagation velocity of electrons under an influence of the nanoscale electric fields, which enables electrical characterization of semiconductor structures.

In some embodiments, determining the diffraction pattern for the area of the sample surface; aggregating the diffraction pattern with one or more of the series of diffraction patterns; and determining the one or more structures on the sample surface based on the aggregating comprises lensless imaging. Note that there may be at least two forms of ptychography, (1) real space ptychography (with measurements in Fourier space), where no imaging lenses are used, from which the name "lensless imaging" is used (e.g., as primarily described herein). There are lenses used for the formation of the probe, though. Secondly, (2) there may be Fourier ptychography, where measurements are images at the real space image plane, and where an imaging lens is used, or an imaging lens with a relatively low detection NA (numerical aperture).

In some embodiments, the one or more processors comprise and/or are configured to execute an algorithm for reconstructing diffraction patterns obtained for different areas of the sample surface into an image.

In some embodiments, determining the one or more structures on the sample surface based on the aggregating comprises retrieving, by specific ptychographic signal processing, an amplitude and phase of an associated coherent particle wavefront, from which the one or more structures are determined.

In some embodiments, determining the diffraction pattern comprises measuring the diffraction pattern by the detector and/or the one or more processors.

According to an embodiment, a metrology method is provided. The method comprises one or more of the operations performed by the system described above.

According to another embodiment, one or more non-transitory, machine-readable medium is provided having instructions thereon, the instructions when executed by a processor being configured to cause the processor to perform and/or otherwise control one or more of the operations performed by the system described above.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figure 1 is a schematic diagram illustrating an exemplary particle beam system, according to an embodiment.
Figure 2 is a schematic diagram of an exemplary particle beam tool, according to an embodiment.
Figure 3 illustrates an example of a low-energy-electron diffractometer (LEED), according to an embodiment.
Figure 4 illustrates coherent diffraction imaging (in reflection mode), according to an embodiment.
Figure 5 illustrates a metrology system (a LEED + ptychography based system), according to an embodiment.
Figure 6 is a flowchart that illustrates a metrology method, according to an embodiment.
Figure 7 is a block diagram of an example computer system, according to an embodiment.
Figure 8 illustrates an example lithography apparatus, according to an embodiment.
Figure 9 illustrates an example lithographic cell or cluster, according to an embodiment.

### DETAILED DESCRIPTION

Low-energy electron diffraction (LEED) and microscopy are technologies based on coherent imaging which may be used for (e.g., after development) defect inspection on wafers in semiconductor applications, for example. Phase information from a reflected electron wavefront in low energy electron microscopy (LEEM) carries information about sample (e.g., wafer) surface structures, including potential defects. As an example, after a development operation during semiconductor manufacturing, some contact holes may have residual resist at their bottoms (which can locally prohibit a typical etching process), which is useful to detect. These defects are referred to as "scum" defects. Phase information of an electron wavefront can be retrieved using LEEM via phase contrast imaging or holography as in optical detection (at visible wavelengths), or via phase retrieval through some kind of diversity, as, e.g. through focus variation.

LEEM is used to image surfaces with elastically reflected electrons that have very low energies. In typical LEEM, electrons are slowed so they have very low energies at or near a sample surface (e.g., < 100 eV). The electrons are decelerated such that they are reflected before, or immediately after, interacting directly with the sample surface. In any event, the electrons do experience the nano-scale electric and magnetic fields at the sample surface. Electrons reflected from the sample surface are rapidly accelerated back to a column energy (e.g., typically 15 keV) and an image of the sample surface is formed by projection lenses.

In a low energy electron diffractometer on the other hand, no projection lenses are needed. In typical LEED, no image is formed at all, only a diffraction pattern. Using ptychography, as described herein, one can reconstruct an image computationally. Instead, an electron diffraction pattern from reflected and diffracted electrons is detected at a detector. A LEED diffraction pattern can be generated based on the interaction of a relatively localized coherent electron particle beam incident on the sample surface. Advantageously, as described herein, LEED is used in combination with ptychography (to generate a series of diffraction patterns which are each associated with a given particle beam position, where particle beams centered at neighboring positions are partially overlapping) to determine semiconductor wafer surface structures through lensless imaging for defect inspection and/or other purposes.

Ptychography is a phase-retrieval approach typically (until now) used for coherent diffractive imaging in a transmission electron microscope (TEM), optical microscopy, or EUV / soft X-ray microscopy (where multiple diffraction patterns and no direct images are being measured). In ptychography, at a (two dimensional - 2D) detector, a series of far-field diffraction patterns are detected and/or otherwise determined. Each diffraction pattern is realized through a localized (electron) particle beam (e.g., functioning as a probe) that is incident on a sample surface at a certain angle. In each diffraction pattern, only powers (modulus squared) of an angularly varying (complex-valued, electron or optical) electron wavefront are detected. A required redundancy that is needed in order to be able to retrieve the phase, is realized through the partial overlap (e.g., of about 60% or more of the sample surface area occupied by a prior neighboring particle beam) of consecutive illuminating particle beams that are focused at the sample. Practically, the sample surface may be scanned in the (e.g., x,y)-plane of the sample surface, resulting in a number of probe positions such that particle beams from neighboring probe positions satisfy a given overlap criterion, which depends on the amount of information and resolution that needs to be retrieved; and for each scan position, a static diffraction pattern is recorded. Aggregated diffraction patterns are used to reconstruct surface structures.

This mode of imaging (LEED + ptychography) can be used to detect defects that are related to the geometry of surface structures. It is useful when height information is desired, which is often very difficult to obtain with conventional scanning electron microscope (SEM) imaging, and/or in other applications. Height information is difficult to determine with standard microscopy techniques since a micrograph is always a 2D projection of the sample. However, ptychography is a technique that can also reconstruct the phase (not only the amplitude) of the reflected wavefront, which contains the height information. Another application is the detection of nanoscale electric fields that lead to phase information due to small changes in the propagation velocity of electrons under the influence of electric fields. This may enable electrical characterization of semiconductor structures, for example. Other advantages and/or applications are contemplated.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. A patterning device (for example, a lithography device) can comprise, or can form, one or more patterns, which may correspond to one or die. The patterns can be generated utilizing CAD (computer-aided design) programs, based on a pattern or design layout, this process often being referred to as EDA (electronic design automation).

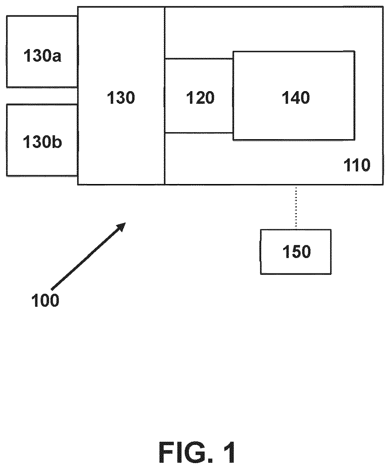

Figure 1 illustrates an exemplary electron beam system 100. As shown in Figure 1, the electron beam system 100 includes a main chamber 110, a load-lock chamber 120, an electron beam tool 140, and an equipment front end module (EFEM) 130. Electron beam tool 140 is located within main chamber 110. The exemplary electron beam system 100 may be a single or multi-beam system (e.g., provided that each beam's diffraction pattern can be separated and recorded by multiple pixelated detectors). While the description and drawings are directed to an electron beam, it should be appreciated that the embodiments of the present disclosure are not limited to specific particles. Electrons may instead or additionally include other charged particles, such as ions, protons, etc. (as in a helium microscope as one example).

EFEM 130 includes a first loading port 130a and a second loading port 130b. EFEM 130 may include additional loading port(s). First loading port 130a and second loading port 130b may receive wafer front opening unified pods (FOUPs) that contain wafers (e.g., semiconductor wafers or wafers made of other material(s) - which may be substrates or samples as described herein) and/or other samples to be inspected (substrates, samples, and/or wafers are collectively referred to as "wafers" hereafter). One or more robot arms (not shown) in EFEM 130 transport the wafers to load-lock chamber 120.

Load-lock chamber 120 is connected to a load/lock vacuum pump system (not shown), which removes gas molecules in load-lock chamber 120 to reach a first pressure below the atmospheric pressure. After reaching the first pressure, one or more robot arms (not shown) transport the wafer from load-lock chamber 120 to main chamber 110. Main chamber 110 is connected to a main chamber vacuum pump system (not shown), which removes gas molecules in main chamber 110 to reach a second pressure below the first pressure. The second pressure may correspond to an ultra-high vacuum (UHV) pressure, such as on the order of 10⁻¹⁰ torr. After reaching the second pressure, the wafer is subject to inspection by electron beam tool 140. In some embodiments, the electron beam tool 140 may comprise a single-beam inspection tool. In some embodiments, the electron beam tool 140 may comprise a multi-beam inspection tool.

Controller 150 may be electronically connected to electron beam tool 140 and may be electronically connected to other components as well. Controller 150 may be a computer configured to execute various controls of electron beam system 100. Controller 150 may also include processing circuitry configured to execute various signal and image processing functions. While controller 150 is shown in Figure 1 as being outside of the structure that includes main chamber 110, load-lock chamber 120, and EFEM 130, it is appreciated that controller 150 can be part of the structure.

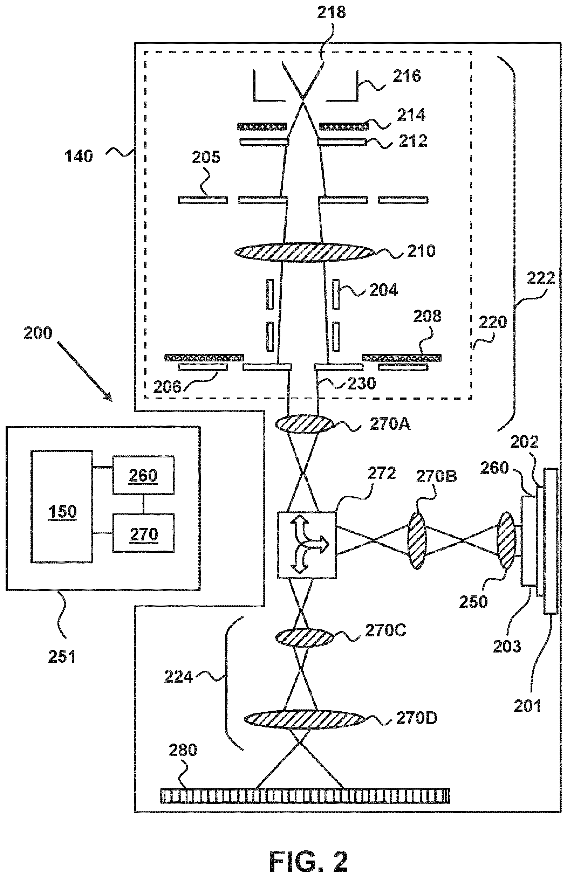

FIG. 2 illustrates schematic diagram of an exemplary imaging system 200. Imaging system 200 is shown in an example LEEM configuration. Electron beam tool 140 of FIG. 1 may be configured for use in electron beam system 100. Electron beam tool 140 may be a single beam apparatus, for example. As shown in FIG. 2, electron beam tool 140 includes a motorized sample stage 201, and a sample holder 202 supported by motorized sample stage 201 to hold a sample such as a wafer 203 to be inspected. Electron beam tool 140 further includes a particle beam generator or an electron beam source 220. The particle beam generator / electron beam source 220 is depicted as having a cathode 218, an anode 216, a gun aperture 214, a beam limit aperture 212, a condenser lens 210, an objective lens 205, an objective lens assembly 204, and an objective aperture 208. The particle beam generator / electron beam source 220 may have more or fewer components.. In embodiments where the electron beam tool 140 is configured to operate in at least some instances as an SEM or for LEED, the electron beam tool 140 may also include deflectors or scanning coils configured to scan an electron beam across the wafer 203. In some embodiments, the electron detector 206 may be omitted or may instead be a lens, collimator, or other beam conditioning element. The components may be integrated into one or more components, such that components depicted as separate elements may be instead integrated elements. For example, the cathode, the anode, and the gun aperture 214 may be part of an electron "gun" which may be an encapsulated electron source.

An electron beam 230 is emitted from cathode 218 by applying a voltage between anode 216 and cathode 218. Electron beam 230 passes through gun aperture 214 and beam limit aperture 212, both of which may determine the size of electron beam entering condenser lens 210, which resides below beam limit aperture 212. Condenser lens 210 focuses electron beam 230 before the beam enters objective aperture 208 to set the size of the electron beam before entering objective lens assembly 204. A deflector may deflect electron beam 230, such as to facilitate focusing of the beam on the wafer 203, beam scanning on the wafer 203, alignment of the electron beam 230, etc. Further, in some embodiments, anode 216 and cathode 218 may be configured to generate multiple electron beams 230.

The electron beam source 220 emits the electron beam 230, which is a coherent electron beam. The electron beam 230, as emitted from the electron beam source 220, may be a high-energy electron beam (e.g., where high energy is a relative measurement and may correspond to 15-20 keV). The electron beam 230, as emitted from the electron beam source 220 may be an electron beam which has been accelerated (e.g., to higher than emission energy) such as by one or more of the cathode 218, the anode 216, a voltage difference between the cathode 218 and the anode 216, the gun aperture 214, the beam limit aperture 212, the condenser lens 210, the objective lens 205, the objective lens assembly 204, the objective aperture 208, and the electron detector 206. The electron beam 230, as emitted from the electron beam source 220, may have a relatively small spot size (e.g., on the order of an SEM spot size or other spot size useful for scanning applications or approximately 0.4 nm to 5 nm). The electron beam 230 may instead have a relatively larger spot size (e.g., a broad beam on the order of with a diameter of approximately 10 µm, including from a diameter of 200 nm or smaller to a diameter of 80 µm or larger) or a spot size otherwise configured for sample area illumination (e.g., of a field of view (FOV)). The electron beam 230 may be produced by a set of illumination optics 222, which may include the electron beam source 220. The illumination optics 222 may also include one or more auxiliary lenses, such as lens 270A, for focusing, collimation, direction, etc.

From the illumination optics 222, the electron beam 230 may pass into a magnetic prism 272. The magnetic prism 272 may direct the electron beam 230 towards the wafer 203. The magnetic prism 272 may also receive electrons reflected by a sample (e.g., the wafer 203), including elastically scattered electrons, inelastically scattered electrons, etc. The magnetic prism 272 may be any appropriate type of electron beam separator, including a magnetic beam separator. The magnetic prism 272 may focus, shape, broaden, narrow, etc. the electron beam 230, including by selecting electrons of a particular energy or range of energies for direction (such as towards the wafer 203 or towards an electron detector 280). The magnetic prism 272 may deflect the electron beam towards a surface of the sample (e.g., the wafer 203). The magnetic prism 272 may deflect electrons reflected from the surface of the sample (e.g., the wafer 203) towards the electron detector 280.

The electron detector 280 may be any appropriate sensor, including a pixelated sensor, a pixelated image detector, a phosphorescent screen (such as for LEED), etc. The electron detector 280 may be used additionally to the electron detector 206 of the electron beam source 220 or may replace the electron detector 206 of the electron beam source 220. Additional electron detectors, not depicted, may be used to detect electrons in other parts of the electron beam tool 140, such as electron detectors which may be placed near the wafer 203 and which may be used to detect inelastically scattered electrons from a surface of the wafer 203, where such inelastically scattered electrons may have energies such that they are not transmitted by the magnetic prism 272 to the electron detector 280. The electron detector 280 may be substantially planar. The electron detector 280 may not have apertures and may be configured to function as a backstop for electrons. The electron detector 280 may time average or time integrate detected electrons. The electron detector 280 may detect a combination of multiple electron beams, including interference between multiple electron beams. The electron detector 280 may detect electrons diffracted by the sample (e.g., the wafer 203), including in a low-energy electron diffraction (LEED) configuration. The electron detector 280 may detect electrons reflected-e.g., elastically-by the sample (e.g., the wafer 203) which are not diffracted. The electron detector 280 may detect an intensity of the incident electron beam on the electron detector 280.

The electron beam 230, such as when it contacts the sample (e.g., the wafer 203), may be any electron beam appropriate for low energy electron microscopy (LEEM) and/or a low energy electron diffractometer (LEED), such as an electron beam which produces a relatively broad and parallel 1-100 eV electron beam. Low energy may include energies lower than an electron emission energy, such as from the cathode 218. Broad may likewise be a relative descriptor relating to spot size (when interacting with a sample) or beam dispersion angle, implying that an entire FOV may be illuminated by the electron beam at one time without substantial scanning. A broad beam may have a diameter of approximately 10 µm, including from a diameter of 200 nm or smaller to a diameter of 80 µm or larger. Parallel may be a descriptor applied to a relatively coherent particle beam, such as with a coherence length on the order of or longer than the beam path (such as from the cathode 218 to the electron detector 280). A broad and parallel beam may be a beam which has both a larger spot size and a small dispersion angle.

The electron beam 230 at the wafer 203 may be a low energy electron beam, such as an electron beam of approximately electron emission energy. The electron beam 230 may be decelerated from a higher energy state by one or more lenses. The electron beam 230 at the wafer 203 may have a relatively large spot size (e.g., as previously described), such as may illuminate a significant portion of a sample, of a field of view (FOV), etc. The area of illumination may be larger than the image resolution-including significantly larger. The electron beam 230 may be a relatively narrow (e.g., as used for traditional SEM) and coherent ~15 keV electron beam in some portions of its path, which may be decelerated and focused into a relatively broad and parallel (e.g., coherent) 1-100 eV electron beam by one or more immersion objective lens, such as lens 250. The sample (e.g., the wafer 203) may be held at substantially the same electric potential as the electron beam source 220, such that the electrons reaching the sample are (e.g., relatively) low-energy (e.g., 1-100 eV) electrons which may experience elastic scattering by the sample. The electron beam 230 may be decelerated, broadened, accelerated, narrowed, etc., such as by one or more lens 270A-270D, along a path of the electron beam 230. The electron beam 230 may be focused, shaped, deflected, re-directed, etc., by one or more element along the paths of the respective electron beams, such as the lenses 270A-270C, magnetic prisms 272, etc. The electrons of the electron beam 230 may elastically scatter at one or more sample (e.g., the wafer 203) or particle mirror, where the particle mirror may be an electrostatic mirror, a magnetic mirror, an electromagnetic mirror, etc. which causes electrons (or other particles) to reflect while maintaining coherence.

The magnetic prism 272 may comprise one or more apertures, where an aperture may be configured to select a contrast for the electron beam (e.g., dark field imaging or bright field imaging). The aperture may be configured to be moveable, e.g., in and out of the electron beam, to select a portion of the beam, etc. The aperture may be configured to select a through beam or one or more diffraction beam received from the sample (e.g., the wafer 203). The one or more apertures may be alternatively or additionally located in other locations along the path of the electron beam 230.

The lenses 270B and 270C may be transfer lenses. Additional transfer lenses or fewer transfer lenses may be used. Transfer lenses may be used to alter the path of the electron beam 230 without changing the image contained therein. The lens 250 may be an electrostatic immersion objective lens. The lenses 270C and 270D may be parts of a set of condenser optics 224, which may include more or fewer lenses. The lens 270D may be one or more projector lens, such as a lens configured to magnify the electron beam 230 for projection on the electron detector 280. The projector lens may conserve the phase of the wavefront (or applying the same phase change across the wavefront) of the electron beam, while spreading the beam size such as to a size visible to the human eye. The projector lens may spread the beam size while conserving phase to a size such that the pixels of the electron detector 280 may detect intensity variations corresponding to recombination of one or more electron beam. The electron detector 280 or associated processing (such as may occur in imaging system 200) may also enlarge, such as to a size visible to the human eye, any detected image. The condenser optics 224 may be or include projection optics, including one or more projector lens.

Imaging system 200 may be used for inspecting a wafer 203 on motorized sample stage 201, and comprises an electron beam tool 140, as discussed above. Imaging system 200 may also comprise an image processing system 251 that includes an image acquirer 260, storage 270, and controller 150 (which may be the controller 150 of Figure 1). Image acquirer 260 may comprise one or more processors. For example, image acquirer 260 may comprise a computer, server, mainframe host, terminals, personal computer, any kind of mobile computing devices, and the like, or a combination thereof. Image acquirer 260 may connect with an electron detector 206 or electron detector 280 of electron beam tool 140 through a medium such as an electrical conductor, optical fiber cable, portable storage media, IR, Bluetooth, internet, wireless network, wireless radio, or a combination thereof. Image acquirer 260 may receive a signal from electron detector 206 or electron detector 280 and may construct an image. Image acquirer 260 may thus acquire images of wafer 203. Image acquirer 260 may also perform various post-processing functions, such as generating contours, superimposing indicators on an acquired image, determining a surface profile, determine a difference in surface depth or material, determining a reconstruction of multiple de-focused images, determining an aberration correction, applying an aberration correction, determining a reconstruction of an image from images at different focus conditions, etc.. Image acquirer 260 may be configured to perform adjustments of brightness, contrast, skew, size, etc. of acquired images. Storage 270 may be a storage medium such as a hard disk, cloud storage, random access memory (RAM), other types of computer readable memory, and the like. Storage 270 may be coupled with image acquirer 260 and may be used for saving raw image data as original images, and post-processed images. Image acquirer 260 and storage 270 may be connected to controller 150. In some embodiments, image acquirer 260, storage 270, and controller 150 may be integrated together as one control unit.

In some embodiments, image acquirer 260 may acquire one or more images of a sample based on an imaging signal received from electron detector 206 or electron detector 280. An imaging signal may correspond to an imaging operation for conducting electron imaging. An acquired image may be a single image comprising a plurality of imaging areas or comprising an imaging area of which some regions are illuminated while other regions may not be illuminated. The single image may be stored in storage 270. The single image may be an original image that may be divided into a plurality of regions. Each of the regions may comprise one imaging area containing a feature of wafer 203.

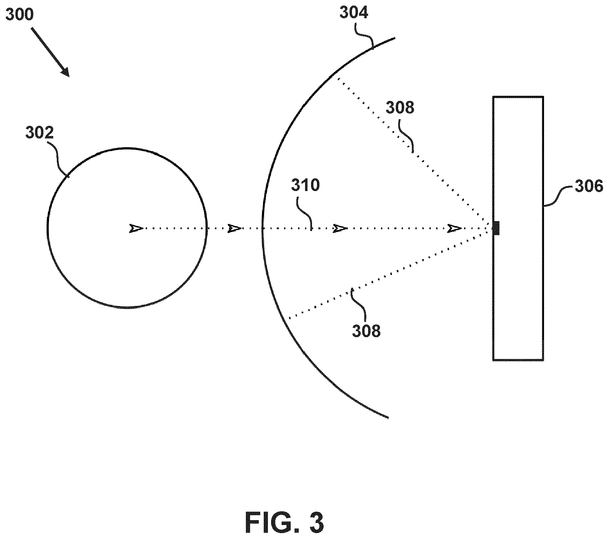

Figure 3 illustrates an example of a low-energy-electron diffractometer 300. The example shown in Figure 3 is lensless. (Note that LEED can be done lensless, but that does not mean that LEED has to be done lensless. The techniques described herein contemplate both options.)

Diffractometer 300 includes a particle beam generator or an electron (e⁻) beam source 302, a detector 304, and/or other components. Figure 3 also illustrates a sample 306 such as a wafer that is reflecting and diffracting electrons 308 from an electron beam 310 emitted by source 302.

Source 302 emits electron beam 310, which is a coherent electron beam. Electron beam 310, as emitted from source 302, may be a high-energy electron beam. Electron beam 310 may have a spot size otherwise configured for sample area illumination (e.g., of a field of view (FOV)). Detector 304 may be a single electron detector, multiple electron detectors, contain multiple electron detector elements, etc. Detector 304 may be any appropriate sensor, including a pixelated sensor, a pixelated image detector, a phosphorescent screen, etc. Detector 304 may detect electrons diffracted by sample 306. Detector 304 may detect electrons reflected-e.g., elastically-by sample 306. In system 300, no projection lenses are needed to form an image, but instead an electron diffraction pattern is registered at detector 304. Such a LEED diffraction pattern can be generated from the interaction of a relatively localized coherent electron probe (e.g., electron beam 310) incident on sample 306.

When it contacts sample 306, electron beam 310 may be any electron beam appropriate for a low energy electron diffractometer (LEED), such as an electron beam which produces a relatively broad and parallel 1-100 eV electron beam. As described above, low energy may be a relative descriptor, such that low energy of an electron corresponds to an electron energy that is substantially non-ionizing when interacting with a surface. Electron beam 310 may be low energy because there is a potential difference, thus retarding an electric field, between a surface of sample 306 surface and an electron optical element (not shown in Figure 3), and electron beam 310 is decelerated by biasing the sample surface at an appropriate potential with respect to an electron source potential.

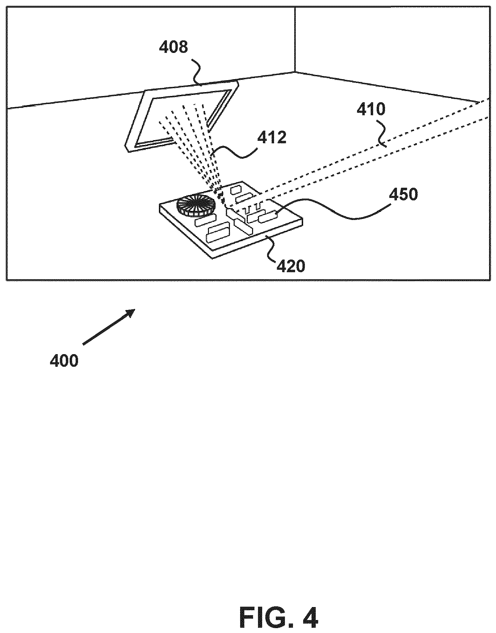

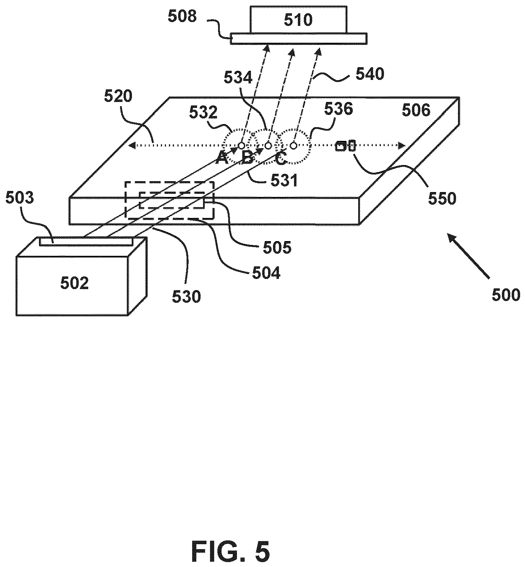

Figure 4 illustrates an example of coherent diffractive imaging 400. Figure 4 illustrates coherent diffractive imaging 400 in reflection mode (a particle or electron beam 410 is reflecting off of a surface of a sample 420) with one position of a focused particle or electron beam 410 probe on sample 420 (out of a series of partially overlapping probes as used in ptychography and describe below with respect to Figure 5). Note that the beam in this figure hits the sample at an angle (i.e., not at normal incidence as is common in LEEM and SEM). Also note that inclined incidence of the beam is not necessary for the systems and methods described herein to work, but is a possible mode of operation.

The surface of sample 420 may be patterned with various structures 450, such as structures that may typically be included in an integrated circuit. Particle or electron beam 410 is a coherent or partially coherent particle beam having a beam energy, a beam size (see spot size of beam 410 on sample 420), and/or other characteristics. A detector 408 is configured to detect reflected and diffracted particles and/or particle beams 412 from the surface of sample 420, for (forming) a reflected (far field) diffraction pattern and/or other purposes. These concepts are explained further with respect to Figure 5.

Figure 5 illustrates a metrology system 500. System 500 is a LEED + ptychography based system. In system 500, instead of a particle or an electron beam being plane-wave like, and diffraction and diffraction images being treated independently of each other, there is a focused (point like) particle or electron beam, and information from multiple probing beams (e.g., acquisitions) is used together to reconstruct sample surface information.

System 500 comprises a particle beam generator 502, an energy reducer 504, a detector 508, one or more processors 510, and/or other components. In some embodiments, system 500 shown in Figure 5 is similar to and/or the same as, and/or has overlapping components with, other systems described herein, such as one or more systems and/or components shown in Figures 1-4. For example, particle beam generator 502, energy reducer 504, detector 508, one or more processors 510, and/or other components of system 500 may comprise a low-energy-electron diffractometer which is configured for measuring electron diffraction patterns. Particle beam generator 502 is configured to scan 520 a sample surface 506 with a particle beam 530 through different probing particle beam 530 positions 532, 534, and 536 (in this example) to generate a series of diffraction patterns (based on reflected and diffracted particles and/or particle beams 540 from sample surface 506), which are sequential in time, and correspond to different but neighboring areas of sample surface 506. This scanning, in combination with aggregating the diffraction patterns in the series of diffraction patterns; and determining one or more structures 550 on sample surface 506 based on the aggregating comprise ptychography operations. This also comprises lensless imaging. As described above, there may be two forms of ptychography, (1) real space ptychography (with measurements in Fourier space), where no imaging lenses are used, from which the name "lensless imaging" is used. There are lenses used for the formation of the probe, though. In contrast with (1), secondly, (2) there may be Fourier ptychography, where measurements are images at the real space image plane, and where an imaging lens is used, or an imaging lens with a relatively low detection NA (numerical aperture).

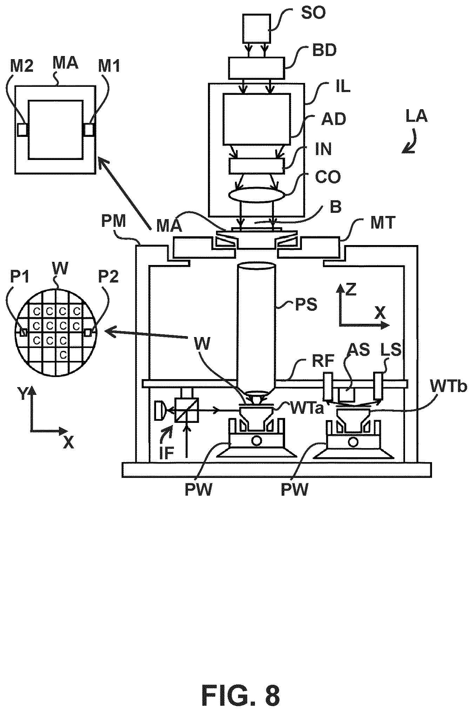

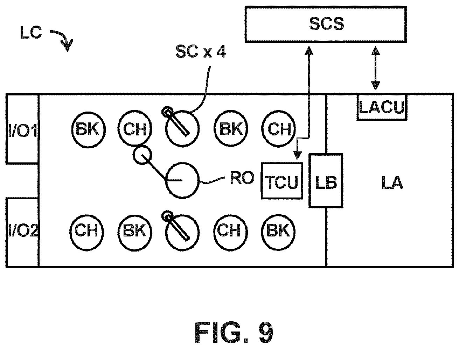

Sample surface 506 may be the surface of a substrate such as a semiconductor wafer, and/or other surfaces. Sample surface 506 may be patterned (e.g., as described below with respect to Figures 8 and 9) with various structures 550, such as structures that may typically be included in an integrated circuit. Examples of such structures include a contact hole, a pillar, a line/space pattern, a slot, a trench, open space, and/or other structures. Each of these structures may have various heights, widths, depths, orientations, and/or other features.

In some embodiments, particle beam generator 502, energy reducer 504, detector 508, one or more processors 510, and/or other components of system 500 may comprise a modified scanning electron microscope (SEM). The modified SEM may have a low landing energy, a relatively localized coherent or partially coherent electron probe, projective optics (e.g., similar to and or the same as the various optical components shown in Figure 2) configured to project a diffraction pattern on pixelated detector 508, an energy filter configured to select elastically scattered electrons, a pixelated detector configured to record a diffraction image, and/or other components. In some embodiments, the pixelated particle detector may be positioned at a given distance from the sample surface. The given distance may be determined based on a target detection numerical aperture (NA) and an associated resolution, and/or other factors.

In some embodiments, a reflected diffraction pattern may be captured directly onto a pixelated detector above the sample, without any projection lenses. In some embodiments, reflected diffraction orders are deflected using a magnetic prim into a second beam line, that includes some projective optics to magnify the diffraction pattern, and a pixelated camera, for example. The position of the camera may depend on the detection NA (range of scattered angles) that one aims to record, and which will determined the resolution in the xy plane. The further the camera is placed from the sample, the larger this detection NA, but also the smaller the retrieved field of view from a single diffraction pattern, so more overlap in scanning positions is needed in such a case.

Particle beam generator 502 is configured to generate particle beam 530. Particle beam 530 is a coherent or partially coherent particle beam having a beam energy, a beam size (see the representative dotted circles in Figure 5) such as a spot size, and/or other characteristics. The spot size may comprise a range of diameters such as about 10-200 nm (depending on the size of the structures on sample surface 506). For example, in some embodiments, the spot size may be about 100nm.

In some embodiments, particle beam 530 may be a coherent electron beam. In some embodiments, particle beam 530 is an electron beam where the particles are electrons. In some embodiments, particle beam 530 is a proton beam and the particles are protons. In some embodiments, particle beam 530 is a helium (He) beam, and the particles are He-ions.

Particle beam generator 502 may comprise a scanner 503 configured such that sample surface 506 is scanned 520 with particle beam 530 (three example sequential particle beams 530 are shown in Figure 5) through different probing particle beam 530 positions 532, 534, and 536 to generate a series of diffraction patterns, which are sequential in time, and correspond to different but neighboring areas of sample surface 506. In some embodiments, particle beam generator 502 is the same as or similar to particle beam generator or electron beam source 220 shown in Figure 2, and/or source 302 shown in Figure 3, for example. Scanning may be performed either with a sample stage or with electron-optical deflectors of the system. Particle beam 530 is the same as or similar to electron beam 230 shown in Figure 2, electron beam 310 shown in Figure 3, and/or particle or electron beam 410 shown in Figure 4. Sample surface 506 may be similar to and/or the same as a surface of wafer 203 shown in Figure 2, a surface of sample 306 shown in Figure 3, and/or a surface of sample 420 shown in Figure 4.

Energy reducer 504 is configured to reduce the beam energy of particle beam 530. In some embodiments, energy reducer 504 is configured to cause particle beam 530 to have a specific beam energy by reducing an initial energy of an initial particle beam from the particle beam generator to a specific (reduced) beam energy. A reduced energy beam 531 is configured to be reflected and diffracted by sample surface 506. Reduced energy beam 531 has a reduced depth of interaction with sample surface 506 compared to that of particle beam 530 with the initial column and/or beam energy. Reduced energy beam 531 may be elastically scattered by sample surface 506. In some embodiments, for example, energy reducer 504 is configured to reduce the beam energy so that reduced energy beam 531 has an energy less than approximately 100 eV. Reduced energy beam 531 is a low-energy electron beam when reflected and diffracted by sample surface 506. Reducing the beam energy, causes reduced energy beam 531 to be reflected and diffracted by electric and/or magnetic fields at sample surface 506, before direct interaction with sample surface 506. This mode can be referred to as mirror mode, or negative landing energy (LE). A negative LE is contemplated, e.g., for an energy of 1-100 eV, as electrons are decelerated all the way to zero in this case.

Energy reducer 504 is not formed by one single physical object, but instead energy reducer 504 is configured such that there is a potential difference, thus retarding an electric field, between sample surface 506 and an electron optical element 505. Particle beam 530 is decelerated by biasing sample surface 506 at an appropriate potential with respect to an electron source (particle beam generator 502) potential. Electron optical element 505 may comprise a lens and/or an aperture, for example, and/or other components. In some embodiments, the particle beam may already have the reduced energy, or the energy of the particle beam may be reduced using some other method, making energy reducer 504 unnecessary.

In some embodiments, system 500 comprises a magnetic prism (similar to and/or the same as magnetic prism 272 shown in Figure 2) configured to change a direction of particle beam 530 toward sample surface 506 and change an opposite direction of reflected electrons (e.g., as similarly shown in Figure 2) towards detector 508. In some embodiments, system 500 comprises one or more deflectors configured to select sample surface 506 locations from which diffraction patterns are obtained. In some embodiments, system 500 comprises an aperture (e.g., similar to and/or the same as beam limit aperture 212 and/or objective aperture 208 shown in Figure 2) and/or lens(es) (e.g., similar to and/or the same as a condenser lens, an auxiliary lens, a transfer lens, a projection lenses, etc., shown in Figure 2, configured to adjust a particle beam diameter, the size of the diffraction pattern and/or other components.

Detector 508 is configured to detect coherently reflected and diffracted particles and/or particle beams 540 from sample surface 506, for (forming) a reflected coherent diffraction pattern and/or other purposes. The reflected and diffracted particles and/or particle beams 540 may comprise an electron wavefront. In some embodiments, detector 508 is a pixelated particle detector, for example. The pixelated particle detector may be positioned at a given distance from the sample surface. The given distance may be determined based on a target detection numerical aperture and an associated resolution, and/or other factors. In some embodiments, detector 508 is the same as or similar to detector 280 shown in Figure 2, detector 304 shown in Figure 3, and/or detector 408 shown in Figure 4.

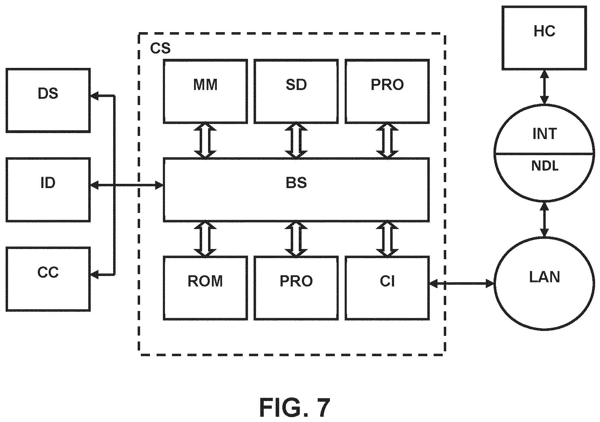

Detector 508 is configured to generate one or more electronic output signals indicative of detections of coherently reflected and diffracted particles and/or particle beams 540 from sample surface 506. The one or more output signals are output to one or more processors 510. One or more processors 510 may form, and/or be the same as or similar to controller 150 shown in Figure 1, image processing system 251 shown in Figure 2 (which includes image acquirer 260 and controller 150), and/or the one or more processors PRO shown in Figure 7 and described below).

One or more processors 510 are configured to determine the diffraction pattern for an area of sample surface 506 corresponding to the beam size (e.g., an area of sample surface 506 designated by one of the example dotted circles in Figure 5) based on detected reflected and diffracted particles and/or particle beams 540. This may comprise or be considered measuring the diffraction pattern by detector 508 and/or one or more processors 510.

One or more processors 510 are configured to aggregate the diffraction pattern (e.g., from an area designated by a first of the dotted circles in Figure 5) with one or more of a series of diffraction patterns corresponding to different areas (e.g., designated by the other dotted circles) of sample surface 506. As described above, these different areas overlap, as shown in Figure 5. For example, diffraction patterns in the series of diffractions patterns are each associated with a given particle beam position (A, B, and C in Figure 5 for example), where particle beams centered at neighboring positions are partially overlapping (e.g., as indicted by the overlapping dotted circles). The diffraction pattern and the one or more of the series of diffraction patterns may be far field, or Fraunhofer, diffraction patterns, for example.

In some embodiments, as described above, each diffraction pattern is realized through a localized particle beam 530 (e.g., a localized probe) that is incident under a certain angle on sample surface 506. In each diffraction pattern as registered on detector 508, only powers (modulus squared) of the angularly varying (complex-valued, electron or optical) wavefront are recorded. The required redundancy that is needed in order to be able to retrieve the phase, is realized through the partial overlap (e.g., of about 60% and higher) of consecutive illumination probes that are focused at the sample. Practically, sample surface 506 is scanned 520 in the (x,y)-plane (left to right or vice versa in Figure 5) of the sample resulting in a number of particle beam 530 (probe) positions (e.g., A, B, and C in Figure 5) such that neighboring probe positions satisfy the above overlap criterion; and for each scan position, a static diffraction pattern is recorded (and then aggregated with other neighboring static diffraction patterns).

One or more processors 510 are configured to determine one or more structures (e.g., structured 550 as a representative example) on sample surface 506 based on the aggregating and/or other information. Determining one or more structures 550 on sample surface 506 based on the aggregating comprises retrieving, by specific ptychographic signal processing, an amplitude and phase of an associated coherent particle wavefront, from which one or more structures 550 are determined. For example, one or more processors 510 are configured to determine phase(s) and/or amplitude(s) of a particle wavefront that is associated with reflected and diffracted particles and/or particle beams 540 from sample surface 506 based on the diffraction pattern with the one or more of the series of diffraction patterns, and determine one or more structures 550 on sample surface 506 at least partially based on determined phase(s) and/or amplitude(s). One or more processors comprise and/or are configured to execute an algorithm for reconstructing diffraction patterns obtained for different areas of sample surface 506 into an image. There are various classes of signal processing algorithms for ptychographic phase retrieval: (1) Wigner-distribution deconvolution; (2) Ptychographical Iterative Engine (PIE); (3) Loss-function based iterative optimization approaches, possibly using automatic differentiation (AD); as several examples.

One or more structures 550 on sample surface 506 may comprise one or more structures in an integrated circuit formed in a semiconductor wafer, for example. Determining one or more structures 550 may comprise defect inspection (for sample such as a wafer). As described above, one or more structures 550 on sample surface 506 may comprise a contact hole, a pillar, a line/space pattern, a slot, a trench, open space, and/or other structures. Determining one or more structures 550 may comprise reconstructing a depth profile of the sample surface based on a determined phase and/or amplitude of an electron waveform of reflected and diffracted electrons. Determining the one or more structures may comprise determining a (e.g., maximum and/or minimum) height and/or depth and/or other characteristics of one or more structures (e.g., a contact hole, a pillar, a line/space pattern, a slot, a trench, open space, and/or other structures) on the sample surface; identifying defects in the depth profile of the sample surface (e.g., defects in and/or associated with a contact hole, a pillar, a line/space pattern, a slot, a trench, open space, and/or other structures), and/or other determinations. Determining the diffraction pattern for the area of sample surface 506; aggregating the diffraction pattern with one or more of the series of diffraction patterns; and determining the one or more structures 550 on sample surface 506 based on the aggregating (and/or other information) comprise ptychography operations.

In some embodiments, one or more processors 510 are configured to detect nanoscale electric fields associated with sample surface 506 based on variation in diffraction patterns caused by changes in a propagation velocity of electrons under an influence of the nanoscale electric fields, which enables electrical characterization of semiconductor structures. As a background, voltage contrast inspection relies on nanoscale electric fields to probe electrical contacts. Exposure of the sample surface to electron or optical irradiation (or even application of a physical contact probe) can result in the localized accumulation and/or dissipation of charge. This may lead to the formation of voltages and electric fields at the sample surface depending on sample electrical properties at and below the surface. Some materials might accumulate more charge than others, and conductive paths below the surface can help dissipate charge. Conductors below the surface can also create (parasitic) capacitive effects that affect the surface voltage generated by an applied amount of charge on the surface depending on the capacitance value. Active devices including transistors can have their conductivity affected by applied charge in a way that depends on their electrical characteristics. Such effects (and more) result in a complex relation between the electrical properties of the sample and potentials present on the surface that vary with location. Incoming low energy electrons will be sensitive to electrical fields associated with these surface potential differences, and can have their energy and direction locally changed by them, which may affect the diffraction patterns in a way that allows extraction of information on the electrical properties, or identification of areas on the sample surface where these properties are deviating from some reference area.

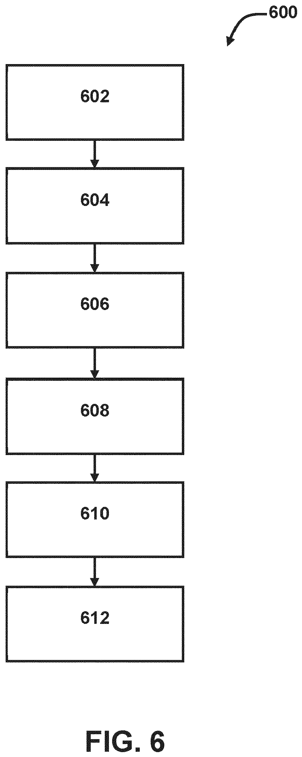

Figure 6 is a flowchart that illustrates a metrology method 600. The operations of method 600 presented below are intended to be illustrative. In some embodiments, method 600 may be accomplished with one or more additional operations not described, and/or without one or more of the operations discussed. Additionally, the order in which the operations of method 600 are illustrated in Figure 6 and described below is not intended to be limiting.

In some embodiments, method 600 may be implemented by metrology system 500 shown in Figure 5 (which may be similar to and/or the same as, and/or have overlapping components with, other systems described herein, such as one or more systems and/or components shown in Figures 1-4). For example, the particle beam generator, the energy reducer, the detector, the one or more processors, and/or other components of system 500 may comprise a low-energy-electron diffractometer (LEED) which is configured for measuring electron diffraction patterns. Scanning a sample surface with a particle beam through different probing particle beam positions to generate a series of diffraction patterns, which are sequential in time, and correspond to different but neighboring areas of the sample surface; determining a diffraction pattern for an area of the sample surface; aggregating the diffraction pattern with one or more of the series of diffraction patterns; and determining the one or more structures on the sample surface based on the aggregating comprise ptychography operations. In method 600, determining the diffraction pattern for the area of the sample surface; aggregating the diffraction pattern with one or more of the series of diffraction patterns; and determining the one or more structures on the sample surface based on the aggregating also comprises lensless imaging.

In some embodiments, the particle beam generator, the energy reducer, the detector, and the one or more processors of system 500 may comprise a modified scanning electron microscope (SEM) configured to perform method 600. The modified SEM has a low landing energy, a relatively localized coherent or partially coherent electron probe, projective optics configured to project a diffraction pattern on the detector, an energy filter configured to select elastically scattered electrons, a pixelated detector configured to record a diffraction image, and/or other components.

In some embodiments, one or more portions of method 600 may be implemented (e.g., by actual performance, simulation, modeling, etc.) in and/or controlled by a computing system (e.g., computing system CS shown in Figure 7 and described below) and/ or one or more processing devices (e.g., one or more processors). The one or more processing devices may include one or more devices executing some or all of the operations of method 600 in response to instructions stored electronically on an electronic storage medium. The one or more processing devices may include one or more devices configured through hardware, firmware, and/or software to be specifically designed for execution of one or more of the operations of method 600, for example.

At an operation 602 a coherent or partially coherent particle beam having a beam energy and beam size is generated with a particle beam generator. In some embodiments, the particle beam may be a coherent electron beam. In some embodiments, the particle beam is an electron beam where the particles are electrons. In some embodiments, particle beam 530 is a proton beam and the particles are protons. In some embodiments, particle beam 530 is a helium (He) beam, and the particles are He-ions. The particle beam generator may comprise a scanner configured such that a sample surface is scanned with the particle beam through different probing particle beam positions to generate a series of diffraction patterns, which are sequential in time, and correspond to different but neighboring areas of the sample surface. In some embodiments, the particle beam generator is the same as or similar to particle beam generator 502 shown in Figure 5 (which may be similar to and/or the same as other components described herein, such as one or more components shown in Figures 1-4, as described above). The sample surface may be similar to and/or the same as sample surface 506 shown in Figure 5 (which also may be similar to and/or the same as a wafer surface or similar described relative to Figures 1-4).

At an operation 604, the beam energy may be reduced with an energy reducer. A reduced energy beam is configured to be reflected and diffracted by a sample surface. The reduced energy beam has a reduced depth of interaction with the sample surface compared to that of the particle beam with the beam energy. The reduced energy beam is a low-energy electron beam when reflected and diffracted by the sample surface. Reducing the beam energy, causes the reduced energy beam to be reflected and diffracted by electric and/or magnetic fields at the sample surface, before direct interaction with the sample surface. The reduced energy beam is elastically scattered by the sample surface. In some embodiments, the particle beam may already have the reduced energy, or the energy of the particle beam may be reduced using some other method, making the energy reducer unnecessary. In some embodiments, the energy reducer is configured to cause the particle beam to have a specific (reduced) beam energy by reducing an initial energy of an initial particle beam from the particle beam generator to the specific (reduced) beam energy.

In some embodiments, for example, the energy reducer is configured to reduce the beam energy so that the reduced energy beam has an energy less than approximately 100 eV. The energy reducer is configured such that there is a potential difference, thus retarding an electric field, between the sample surface and an electron optical element. The particle beam is decelerated by biasing the sample surface at an appropriate potential with respect to an electron source potential. The electron optical element may comprise a probe forming lens generating a relatively localized coherent particle beam that illuminates the sample surface and/or an aperture, for example, and/or other components. In some embodiments, the energy reducer may be similar to and/or the same as energy reducer 504 shown in Figure 5 (which may be similar to and/or the same as other components described herein, such as one or more components shown in Figures 1-4, as described above).

In some embodiments, operation 604 comprises changing, with a magnetic prism, a direction of the particle beam toward the sample surface and changing an opposite direction of reflected electrons towards the detector, using one or more deflectors to select sample surface locations from which diffraction patterns are obtained, using an aperture and/or lens to adjust a particle beam diameter, and/or other operations.

At an operation 606, reflected and diffracted particles and/or particle beams from the sample surface are detected with a detector, for (forming) a reflected diffraction pattern. The reflected and diffracted particles and/or particle beams may comprise an electron wavefront. In some embodiments, the detector is a pixelated particle detector, for example. In some embodiments, the detector is the same as or similar to detector 508 shown in Figure 5 (which may be similar to and/or the same as other components described herein, such as one or more components shown in Figures 1-4, as described above).

At an operation 608, one or more processors are used to determine the diffraction pattern for an area of the sample surface corresponding to the beam size based on detected reflected and diffracted particles and/or particle beams. This may comprise or be considered measuring the diffraction pattern by the detector and/or the one or more processors.

At an operation 610, the one or more processors are configured to aggregate the diffraction pattern with one or more of a series of diffraction patterns corresponding to different areas of the sample surface. Diffraction patterns in the series of diffractions patterns are each associated with a given particle beam position, where particle beams centered at neighboring positions are partially overlapping. The diffraction pattern and the one or more of the series of diffraction patterns may be far field, or Fraunhofer, diffraction patterns.

At an operation 612, the one or more processors are configured to determine one or more structures on the sample surface based on the aggregating. Determining the one or more structures on the sample surface based on the aggregating comprises retrieving, by specific ptychographic signal processing, an amplitude and phase of an associated coherent particle wavefront, from which the one or more structures are determined. For example, the one or more processors are configured to determine phase(s) and/or amplitude(s) of a particle wavefront that is associated with reflected and diffracted particles and/or particle beams from the sample surface based on the diffraction pattern with the one or more of the series of diffraction patterns, and determine the one or more structures on the sample surface at least partially based on determined phase(s) and/or amplitude(s).

The one or more processors comprise and/or are configured to execute an algorithm for reconstructing diffraction patterns obtained for different areas of the sample surface into an image. Determining the diffraction pattern for the area of the sample surface; aggregating the diffraction pattern with one or more of the series of diffraction patterns; and determining the one or more structures on the sample surface (using the algorithm) based on the aggregating comprise ptychography operations, for example.

The one or more structures on the sample surface may comprise one or more structures in an integrated circuit formed in a semiconductor wafer, for example. Determining the one or more structures may comprise defect inspection (for the wafer). The one or more structures on the sample surface comprise a contact hole, a pillar, a line/space pattern, a slot, a trench, open space, and/or other structures. Determining the one or more structures may comprise reconstructing a depth profile of the sample surface based on a determined phase and/or amplitude of an electron waveform of reflected and diffracted electrons. Determining the one or more structures may comprise identifying defects in the depth profile of the sample surface (e.g., defects in and/or associated with a contact hole, a pillar, a line/space pattern, a slot, a trench, open space, and/or other structures).

In some embodiments, the one or more processors associated with operations 608-610 are the same as or similar to one or more processors 510 shown in Figure 5 (which may be similar to and/or the same as other components described herein, such as a controller and/or one or more components shown in Figures 1-4, as described above, and/or one or more of the processors associated with computing system CS shown in Figure 7 and described below).

In some embodiments, as described above, the one or more processors are configured to detect nanoscale electric fields associated with the sample surface based on variation in diffraction patterns caused by changes in a propagation velocity of electrons under an influence of the nanoscale electric fields, which enables electrical characterization of semiconductor structures.

In some embodiments, inspection by LEED + ptychography as described herein (e.g., method 600) may be used to detect defects that are less likely to be detected by SEM or other metrology tools, including photoresist scum or other incomplete development in lithography features (sample surface structures) at an after development inspection (ADI), for example. Photoresist which remains in lithography features after development may not be substantially detectable using SEM inspection, because of the non-crystalline nature of the photoresist scum, because of the thinness of any remaining layer, because of intensity of SEs and BSEs emitted from the photoresist, etc. In order to improve the fabrication process in general and an after etch inspection (AEI) in particular, for example, it may be beneficial to measure scum and other defects which may cause missing lithography features (sample surface structures), such as to better characterize, control, etc. the lithography process, to allow for wafer re-processing in a certain threshold of defects are detected, to improve metrology, etc.

In some cases, whether a surface structure is patterned (and filled) correctly may be determined by voltage-contrast SEM imaging at AEI. However, this measurement may require that a fill step be performed before measurement (e.g., after an etched structure is filled with a metal and biased), which may eliminate chances to re-pattern the sample (wafer) while still in a photoresist (e.g., lithography) step and which may conflate lithography, etch, and fill defects (such as by detecting failure on any of multiple steps) and thus not correspond specifically to a lithography failure. In some embodiments described herein, LEED + ptychography may be used to improve measurement of lithography outcomes and may thereby improve a lithography patterning process or knowledge of a lithography patterning process. As described previously, LEED + ptychography may be used to determine a surface profile, including my reconstruction of a waveform through interference, phase shifting, etc.

In some embodiments, LEED + ptychography may provide benefits over other metrology techniques, such as SEM, for imaging in semiconductor fabrication. For example, LEED + ptychography, which may use relatively low energy electrons (e.g., with energies less than 100 eV, in some embodiments), may allow for imaging of photoresist without generating damage to the photoresist, where photoresist damage (such as burn in) may occur in some SEM applications. In some embodiments, LEED + ptychography may provide information about both phase and amplitude of reflected wavefronts, which may be used to reach resolution of up to 1 nm in both lateral and depth directions. In some embodiments, LEED + ptychography may have a field of view (FOV) of approximately 6 µm (of a greater or smaller FOV dimension in one or more direction), which may allow for measuring of defect rates for many contact holes (as one example structure) in one image, and which may be acceptable for high throughput wafer fabrication, calibration, process control, etc.

Figure 7 is a diagram of an example computer system CS that may be used for and/or to otherwise control one or more of the operations described herein. Computer system CS includes a bus BS or other communication mechanism for communicating information, and a processor PRO (or multiple processors) coupled with bus BS for processing information. Computer system CS also includes a main memory MM, such as a random-access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, portions of one or more methods and/or other operations described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multiprocessing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" and/or "machine readable medium" refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method and/or other operations described herein, for example. The received code may be executed by processor PRO as it is received, and/or stored in storage device SD, or other non-volatile storage for later execution. In this manner, computer system CS may obtain application code in the form of a carrier wave.

To further enhance the reader's understanding of one or more of the concepts discussed above (e.g., a patterning process configured to impart sample surface structures to a semiconductor wafer, exposure, resist, etc.), Figures 8 and 9 illustrate various additional concepts related to semiconductor manufacturing and/or inspection.

For example, Figure 8 schematically depicts an embodiment of a lithographic apparatus LA. The apparatus comprises an illumination system (illuminator) IL configured to condition a radiation beam B (e.g. UV radiation, DUV radiation, or EUV radiation); a support structure (e.g. a mask table) MT constructed to support a patterning device (e.g. a mask) MA and connected to a first positioner PM configured to accurately position the patterning device in accordance with certain parameters; a substrate table (e.g. a wafer table) WT (e.g., WTa, WTb or both) configured to hold a substrate sample (e.g. a resist coated wafer) W and coupled to a second positioner PW configured to accurately position the substrate in accordance with certain parameters; and a projection system (e.g. a refractive projection lens system) PS configured to project a pattern imparted to the radiation beam B by patterning device MA onto a target portion C (e.g. comprising one or more dies and often referred to as fields) of the substrate W. The projection system is supported on a reference frame RF. As depicted, the apparatus is of a transmissive type (e.g. employing a transmissive mask). Alternatively, the apparatus may be of a reflective type (e.g. employing a programmable mirror array, or employing a reflective mask).

The illuminator IL receives a beam of radiation from a radiation source SO. (Note that source SO is typically separate from the metrology system radiation source described above.) The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases, the source may be an integral part of the apparatus, for example when the source is a mercury lamp. The source SO and the illuminator IL, together with the beam delivery system BD if required, may be referred to as a radiation system.

The illuminator IL may alter the intensity distribution of the beam. The illuminator may be arranged to limit the radial extent of the radiation beam such that the intensity distribution is non-zero within an annular region in a pupil plane of the illuminator IL. Additionally or alternatively, the illuminator IL may be operable to limit the distribution of the beam in the pupil plane such that the intensity distribution is non-zero in a plurality of equally spaced sectors in the pupil plane. The intensity distribution of the radiation beam in a pupil plane of the illuminator IL may be referred to as an illumination mode.

The illuminator IL may comprise adjuster AD configured to adjust the (angular / spatial) intensity distribution of the beam. Generally, at least the outer and/or inner radial extent (commonly referred to as σ-outer and σ-inner, respectively) of the intensity distribution in a pupil plane of the illuminator can be adjusted. The illuminator IL may be operable to vary the angular distribution of the beam. For example, the illuminator may be operable to alter the number, and angular extent, of sectors in the pupil plane wherein the intensity distribution is non-zero. By adjusting the intensity distribution of the beam in the pupil plane of the illuminator, different illumination modes may be achieved. For example, by limiting the radial and angular extent of the intensity distribution in the pupil plane of the illuminator IL, the intensity distribution may have a multi-pole distribution such as, for example, a dipole, quadrupole or hexapole distribution. A desired illumination mode may be obtained, e.g., by inserting an optic which provides that illumination mode into the illuminator IL or using a spatial light modulator.

In addition, the illuminator IL generally comprises various other components, such as an integrator IN and a condenser CO. The illumination system may include various types of optical components, such as refractive, reflective, magnetic, electromagnetic, electrostatic or other types of optical components, or any combination thereof, for directing, shaping, or controlling radiation. Thus, the illuminator provides a conditioned beam of radiation B, having a desired uniformity and intensity distribution in its cross section.

The support structure MT supports the patterning device MA in a manner that depends on the orientation of the patterning device, the design of the lithographic apparatus, and other conditions, such as for example whether or not the patterning device is held in a vacuum environment. The support structure may use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a pattern in a target portion of the substrate. In an embodiment, a patterning device is any device that can be used to impart a radiation beam with a pattern in its cross-section to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in a target portion of the device, such as an integrated circuit.

The projection system PS may comprise a plurality of optical (e.g., lens) elements and may further comprise an adjustment mechanism configured to adjust one or more of the optical elements to correct for aberrations (phase variations across the pupil plane throughout the field). To achieve this, the adjustment mechanism may be operable to manipulate one or more optical (e.g., lens) elements within the projection system PS in one or more different ways. The projection system may have a coordinate system wherein its optical axis extends in the z direction. The adjustment mechanism may be operable to do any combination of the following: displace one or more optical elements; tilt one or more optical elements; and/or deform one or more optical elements. Displacement of an optical element may be in any direction (x, y, z, or a combination thereof). Tilting of an optical element is typically out of a plane perpendicular to the optical axis, by rotating about an axis in the x and/or y directions although a rotation about the z axis may be used for a non-rotationally symmetric aspherical optical element. Deformation of an optical element may include a low frequency shape (e.g. astigmatic) and/or a high frequency shape (e.g. free form aspheres). Deformation of an optical element may be performed for example by using one or more actuators to exert force on one or more sides of the optical element and/or by using one or more heating elements to heat one or more selected regions of the optical element. In general, it may not be possible to adjust the projection system PS to correct for apodization (transmission variation across the pupil plane). The transmission map of a projection system PS may be used when designing a patterning device (e.g., mask) MA for the lithography apparatus LA. Using a computational lithography technique, the patterning device MA may be designed to at least partially correct for apodization.

The lithographic apparatus may be of a type having two (dual stage) or more tables (e.g., two or more substrate tables WTa, WTb, two or more patterning device tables, a substrate table WTa and a table WTb below the projection system without a substrate that is dedicated to, for example, facilitating measurement, and/or cleaning, etc.). In such "multiple stage" machines, the additional tables may be used in parallel, or preparatory steps may be conducted on one or more tables while one or more other tables are being used for exposure. For example, alignment measurements using an alignment sensor AS and/or level (height, tilt, etc.) measurements using a level sensor LS may be made.

The lithographic apparatus LA may also be of a type wherein at least a portion of the substrate may be covered by a liquid having a relatively high refractive index, e.g. water, to fill a space between the projection system and the substrate. An immersion liquid may also be applied to other spaces in the lithographic apparatus, for example, between the patterning device and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

In operation of the lithographic apparatus, a radiation beam is conditioned and provided by the illumination system IL. The radiation beam B is incident on the patterning device (e.g., mask) MA, which is held on the support structure (e.g., mask table) MT, and is patterned by the patterning device. Having traversed the patterning device MA, the radiation beam B passes through the projection system PS, which focuses the beam onto a target portion C of the substrate W. With the aid of the second positioner PW and position sensor IF (e.g. an interferometric device, linear encoder, 2-D encoder or capacitive sensor), the substrate table WT can be moved accurately, e.g. to position different target portions C in the path of the radiation beam B. Similarly, the first positioner PM and another position sensor (which is not explicitly depicted in Fig. 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner), the support structure MT may be connected to a short-stroke actuator only, or may be fixed. Patterning device MA and substrate W may be aligned using patterning device alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dies.

The depicted apparatus may be used in at least one of the following modes. In step mode, the support structure MT and the substrate table WT are kept essentially stationary, while a pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure. In scan mode, the support structure MT and the substrate table WT are scanned synchronously while a pattern imparted to the radiation beam is projected onto a target portion C (i.e. a single dynamic exposure). The velocity and direction of the substrate table WT relative to the support structure MT may be determined by the (de-) magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. In another mode, the support structure MT is kept essentially stationary holding a programmable patterning device, and the substrate table WT is moved or scanned while a pattern imparted to the radiation beam is projected onto a target portion C. In this mode, generally a pulsed radiation source is employed, and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above-described modes of use or entirely different modes of use may also be employed.

The substrate (e.g., a sample as described above) may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already includes multiple processed layers.

The terms "radiation" and "beam" used with respect to lithography (related to Figures 8 and 9) encompass all types of electromagnetic radiation, including ultraviolet (UV) or deep ultraviolet (DUV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

Various patterns on or provided by a patterning device may have different process windows. i.e., a space of processing variables under which a pattern will be produced within specification. Examples of pattern specifications that relate to potential systematic defects include checks for necking, line pull back, line thinning, CD, edge placement, overlapping, resist top loss, resist undercut and/or bridging. The process window of the patterns on a patterning device or an area thereof may be obtained by merging (e.g., overlapping) process windows of each individual pattern. The boundary of the process window of a group of patterns comprises boundaries of process windows of some of the individual patterns. In other words, these individual patterns limit the process window of the group of patterns.

As shown in Figure 9, the lithographic apparatus LA may form part of a lithographic cell LC, also sometimes referred to a lithocell or cluster, which also includes apparatuses to perform pre- and post-exposure processes on a substrate. Conventionally these include one or more spin coaters SC to deposit one or more resist layers, one or more developers to develop exposed resist, one or more chill plates CH and/or one or more bake plates BK. A substrate handler, or robot, RO picks up one or more substrates from input/output port I/O 1, I/O2, moves them between the different process apparatuses and delivers them to the loading bay LB of the lithographic apparatus. These apparatuses, which are often collectively referred to as the track, are under the control of a track control unit TCU which is itself controlled by the supervisory control system SCS, which also controls the lithographic apparatus via lithography control unit LACU. Thus, the different apparatuses can be operated to maximize throughput and processing efficiency.

In order that a substrate that is exposed by the lithographic apparatus is exposed correctly and consistently and/or in order to monitor a part of the patterning process (e.g., a device manufacturing process) that includes at least one pattern transfer step (e.g., an optical lithography step), it is desirable to inspect a substrate or other object to measure or determine one or more properties such as alignment, overlay (which can be, for example, between structures in overlying layers or between structures in a same layer that have been provided separately to the layer by, for example, a double patterning process), line thickness, critical dimension (CD), focus offset, a material property, a surface profile, shapes and/or dimensions of various surface structures, etc. Accordingly, a manufacturing facility in which lithocell LC is located also typically includes a metrology system that measures some or all of the substrates W that have been processed in the lithocell or other objects in the lithocell. The metrology system may be part of the lithocell LC, for example it may be part of the lithographic apparatus LA).

The one or more measured parameters may include, for example, alignment, overlay between successive layers formed in or on the patterned substrate, critical dimension (CD) (e.g., critical linewidth) of, for example, features formed in or on the patterned substrate, focus or focus error of an optical lithography step, dose or dose error of an optical lithography step, optical aberrations of an optical lithography step, etc. This measurement is often performed on one or more dedicated metrology targets provided on the substrate. The measurement can be performed after-development of a resist but before etching, after-etching, after deposition, and/or at other times.

Thus, in a device fabrication process (e.g., a patterning process or a lithography process), a substrate or other objects may be subjected to various types of measurement during or after the process. The measurement may determine whether a particular substrate is defective, may establish adjustments to the process and apparatuses used in the process (e.g., aligning two layers on the substrate or aligning the patterning device to the substrate), may measure the performance of the process and the apparatuses, or may be for other purposes. Examples of measurement include optical imaging (e.g., optical microscope), non-imaging optical measurement (e.g., measurement based on diffraction such as the ASML YieldStar metrology tool, the ASML SMASH metrology system), mechanical measurement (e.g., profiling using a stylus, atomic force microscopy (AFM)), and/or non-optical imaging (e.g., the imaging techniques described above).

Metrology results may be provided directly or indirectly to the supervisory control system SCS. If an error is detected, an adjustment may be made to exposure of a subsequent substrate (especially if the inspection can be done soon and fast enough that one or more other substrates of the batch are still to be exposed) and/or to subsequent exposure of the exposed substrate. Also, an already exposed substrate may be stripped and reworked to improve yield, or discarded, thereby avoiding performing further processing on a substrate known to be faulty. In a case where only some target portions of a substrate are faulty, further exposures may be performed only on those target portions which meet specifications. Other manufacturing process adjustments are contemplated.

A metrology system may be used to determine one or more properties of the substrate structure, and in particular, how one or more properties of different substrate structures vary, or different layers of the same substrate structure vary from layer to layer. The metrology system may be integrated into the lithographic apparatus LA or the lithocell LC, or may be a stand-alone device.

Various embodiments of the present systems and methods are disclosed in the subsequent list of numbered clauses. In the following, further features, characteristics, and exemplary technical solutions of the present disclosure will be described in terms of clauses that may be optionally claimed in any combination:
Clause 1. A metrology system, comprising: a particle beam generator configured to generate a coherent or partially coherent particle beam having a beam energy and beam size; a detector configured to detect intensity information from reflected and diffracted particle beams and their associated wavefronts from a sample surface, for a reflected diffraction pattern; wherein the reflected and diffracted particle beams result from reflection and diffraction of the particle beam by the sample surface, the beam energy configured such that the particle beam is reflected and diffracted before direct interaction with the sample surface; and one or more processors configured by machine-readable instructions to: determine the diffraction pattern for an area of the sample surface corresponding to the beam size based on detected reflected and diffracted particle beams; aggregate the diffraction pattern with one or more of a series of diffraction patterns corresponding to different areas of the sample surface; and determine one or more structures on the sample surface based on the aggregating.
Clause 2. The system of clause 1, wherein diffraction patterns in the series of diffractions patterns are each associated with a given particle beam position, and wherein particle beams centered at neighboring positions are partially overlapping.
Clause 3. The system of any of the previous clauses, wherein the particle beam generator, the detector, and the one or more processors comprise a low-energy-electron diffractometer which is configured for measuring electron diffraction patterns.
Clause 4. The system of any of the previous clauses, wherein the particle beam is: an electron beam and particles are electrons; a proton beam and particles are protons; or a helium (He) beam, and the particles are He-ions.
Clause 5. The system of any of the previous clauses, wherein the reflected and diffracted particle beams comprise a particle wavefront, being an electron wavefront, or a proton wavefront, or an He-ion wavefront.
Clause 6. The system of any of the previous clauses, wherein the particle beam generator comprises a scanner configured such that the sample surface is scanned with the particle beam through different probing particle beam positions to generate the series of diffraction patterns, which are sequential in time, and correspond to different but neighboring areas of the sample surface; and wherein scanning is performed either with a sample stage or with electron-optical deflectors of the metrology system.
Clause 7. The system of any of the previous clauses, wherein determining the diffraction pattern for the area of the sample surface; aggregating the diffraction pattern with one or more of the series of diffraction patterns; and determining the one or more structures on the sample surface based on the aggregating comprise ptychography operations.
Clause 8. The system of any of the previous clauses, wherein the diffraction pattern and the one or more of the series of diffraction patterns are far field, or Fraunhofer, diffraction patterns.
Clause 9. The system of any of the previous clauses, wherein the one or more processors are further configured to determine phase(s) and/or amplitude(s) of a particle wavefront that is associated with reflected and diffracted particle beams from the sample surface based on the diffraction pattern with the one or more of the series of diffraction patterns, and determine the one or more structures on the sample surface at least partially based on determined phase(s) and/or amplitude(s).
Clause 10. The system of any of the previous clauses, further comprising an energy reducer configured to cause the particle beam to have the beam energy by reducing an initial energy of an initial particle beam from the particle beam generator to the beam energy; wherein the energy reducer is configured such that there is a potential difference, thus retarding an electric field, between the sample surface and an electron optical element, and wherein the initial particle beam is decelerated by biasing the sample surface at an appropriate potential with respect to an electron source potential.
Clause 11. The system of any of the previous clauses, wherein the electron optical element comprises a probe forming lens generating a relatively localized coherent particle beam that illuminates the sample surface and/or an aperture.
Clause 12. The system of any of the previous clauses, further comprising a magnetic prism configured to change a direction of the particle beam toward the sample surface and change an opposite direction of reflected electrons towards the detector, one or more deflectors configured to be used to select sample surface locations from which diffraction patterns are obtained, and/or an aperture and/or lens configured to be used to adjust a particle beam diameter.
Clause 13. The system of any of the previous clauses, wherein an energy reducer is configured to reduce an initial beam energy to the beam energy so that the particle beam has an energy less than approximately 100 eV.
Clause 14. The system of any of the previous clauses, wherein the particle beam is a coherent electron beam.
Clause 15. The system of any of the previous clauses, further comprising an energy reducer configured to cause the particle beam to have the beam energy by reducing an initial energy of an initial particle beam from the particle beam generator to the beam energy; wherein reducing the beam energy causes the particle beam to be reflected and diffracted by electric and/or magnetic fields at the sample surface, before direct interaction with the sample surface.
Clause 16. The system of any of the previous clauses, wherein the particle beam is elastically scattered by the sample surface.
Clause 17. The system of any of the previous clauses, wherein the particle beam is a low-energy electron beam when reflected and diffracted by the sample surface.
Clause 18. The system of any of the previous clauses, wherein the detector is a pixelated particle detector at a given distance from the sample surface, the given distance based on a target detection numerical aperture (NA) and an associated resolution .
Clause 19. The system of any of the previous clauses, wherein the one or more structures on the sample surface comprise one or more structures in an integrated circuit formed in a semiconductor wafer.
Clause 20. The system of any of the previous clauses, wherein the one or more structures on the sample surface comprise a contact hole, a pillar, a line/space pattern, a slot, a trench, and/or open space.
Clause 21. The system of any of the previous clauses, wherein determining the one or more structures comprises a measurement action referred to as defect inspection.
Clause 22. The system of any of the previous clauses, wherein determining the one or more structures comprises reconstructing a depth profile of the sample surface based on a determined phase and/or amplitude of an electron waveform of reflected and diffracted electrons.
Clause 23. The system of any of the previous clauses, wherein determining the one or more structures comprises identifying defects in a depth profile of the sample surface.
Clause 24. The system of any of the previous clauses, wherein the one or more processors are further configured to detect nanoscale electric fields associated with the sample surface based on variation in diffraction patterns caused by changes in a propagation velocity of electrons under an influence of the nanoscale electric fields, which enables electrical characterization of semiconductor structures.
Clause 25. The system of any of the previous clauses, wherein determining the diffraction pattern for the area of the sample surface; aggregating the diffraction pattern with one or more of the series of diffraction patterns; and determining the one or more structures on the sample surface based on the aggregating comprises lensless imaging.
Clause 26. The system of any of the previous clauses, wherein the one or more processors comprise and/or are configured to execute an algorithm for reconstructing diffraction patterns obtained for different areas of the sample surface into an image.
Clause 27. The system of any of the previous clauses, wherein determining the one or more structures on the sample surface based on the aggregating comprises retrieving, by specific ptychographic signal processing, an amplitude and phase of an associated coherent particle wavefront, from which the one or more structures are determined.
Clause 28. The system of any of the previous clauses, further comprising an energy reducer configured to cause the particle beam to have the beam energy by reducing an initial energy of an initial particle beam from the particle beam generator to the beam energy; wherein the particle beam has a reduced depth of interaction with the sample surface compared to that of the initial particle beam with the initial beam energy.
Clause 29. The system of any of the previous clauses, wherein determining the diffraction pattern comprises measuring the diffraction pattern by the detector and/or the one or more processors.
Clause 30. The system of any of the previous clauses, wherein the particle beam generator, the detector, and the one or more processors comprise a modified scanning electron microscope (SEM), the modified SEM having a low landing energy, a relatively localized coherent or partially coherent electron probe, projective optics configured to project a diffraction pattern on the detector, an energy filter configured to select elastically scattered electrons, and a pixelated detector configured to record a diffraction image.
Clause 31. A metrology method, comprising: generating, with a particle beam generator, a coherent or partially coherent particle beam having a beam energy and beam size; detecting, with a detector, intensity information from reflected and diffracted particle beams and their associated wavefronts from a sample surface, for a reflected diffraction pattern; wherein the reflected and diffracted particle beams result from reflection and diffraction of the particle beam by the sample surface, the beam energy configured such that the particle beam is reflected and diffracted before direct interaction with the sample surface; aggregating, with the one or more processors, the diffraction pattern with one or more of a series of diffraction patterns corresponding to different areas of the sample surface; and determining, with the one or more processors, one or more structures on the sample surface based on the aggregating.
Clause 32. The method of clause 31, wherein diffraction patterns in the series of diffractions patterns are each associated with a given particle beam position, and wherein particle beams centered at neighboring positions are partially overlapping.
Clause 33. The method of any of the previous clauses, wherein the particle beam generator, the energy reducer, the detector, and the one or more processors comprise a low-energy-electron diffractometer which is configured for measuring electron diffraction patterns.
Clause 34. The method of any of the previous clauses, wherein the particle beam is: an electron beam and particles are electrons; a proton beam and particles are protons; or a helium (He) beam, and the particles are He-ions.
Clause 35. The method of any of the previous clauses, wherein the reflected and diffracted particle beams comprise a particle wavefront, being an electron wavefront, or a proton wavefront, or an He-ion wavefront.
Clause 36. The method of any of the previous clauses, wherein the particle beam generator comprises a scanner configured such that the sample surface is scanned with the particle beam through different probing particle beam positions to generate the series of diffraction patterns, which are sequential in time, and correspond to different but neighboring areas of the sample surface; and wherein scanning is performed either with a sample stage or with electron-optical deflectors of a metrology system.
Clause 37. The method of any of the previous clauses, wherein determining the diffraction pattern for the area of the sample surface; aggregating the diffraction pattern with one or more of the series of diffraction patterns; and determining the one or more structures on the sample surface based on the aggregating comprise ptychography operations.
Clause 38. The method of any of the previous clauses, wherein the diffraction pattern and the one or more of the series of diffraction patterns are far field, or Fraunhofer, diffraction patterns.
Clause 39. The method of any of the previous clauses, wherein the one or more processors are further configured to determine phase(s) and/or amplitude(s) of a particle wavefront that is associated with reflected and diffracted particle beams from the sample surface based on the diffraction pattern with the one or more of the series of diffraction patterns, and determine the one or more structures on the sample surface at least partially based on determined phase(s) and/or amplitude(s).
Clause 40. The method of any of the previous clauses, further comprising causing, with an energy reducer, the particle beam to have the beam energy by reducing an initial energy of an initial particle beam from the particle beam generator to the beam energy; wherein the energy reducer is configured such that there is a potential difference, thus retarding an electric field, between the sample surface and an electron optical element, and wherein the initial particle beam is decelerated by biasing the sample surface at an appropriate potential with respect to an electron source potential.
Clause 41. The method of any of the previous clauses, wherein the electron optical element comprises a probe forming lens generating a relatively localized coherent particle beam that illuminates the sample surface and/or an aperture.
Clause 42. The method of any of the previous clauses, further comprising: changing, with a magnetic prism, a direction of the particle beam toward the sample surface and changing an opposite direction of reflected electrons towards the detector, using one or more deflectors to select sample surface locations from which diffraction patterns are obtained, and/or using an aperture and/or lens to adjust a particle beam diameter.
Clause 43. The method of any of the previous clauses, wherein an energy reducer is configured to reduce an initial beam energy to the beam energy so that the particle beam has an energy less than approximately 100 eV.
Clause 44. The method of any of the previous clauses, wherein the particle beam is a coherent electron beam.
Clause 45. The method of any of the previous clauses, further comprising causing, with an energy reducer, the particle beam to have the beam energy by reducing an initial energy of an initial particle beam from the particle beam generator to the beam energy; wherein reducing the beam energy causes the particle beam to be reflected and diffracted by electric and/or magnetic fields at the sample surface, before direct interaction with the sample surface.
Clause 46. The method of any of the previous clauses, wherein the particle beam is elastically scattered by the sample surface.
Clause 47. The method of any of the previous clauses, wherein the particle beam is a low-energy electron beam when reflected and diffracted by the sample surface.
Clause 48. The method of any of the previous clauses, wherein the detector is a pixelated particle detector at a given distance from the sample surface, the given distance based on a target detection numerical aperture (NA) and an associated resolution.
Clause 49. The method of any of the previous clauses, wherein the one or more structures on the sample surface comprise one or more structures in an integrated circuit formed in a semiconductor wafer.
Clause 50. The method of any of the previous clauses, wherein the one or more structures on the sample surface comprise a contact hole, a pillar, a line/space pattern, a slot, a trench, and/or open space.
Clause 51. The method of any of the previous clauses, wherein determining the one or more structures comprises a measurement action referred to as defect inspection.
Clause 52. The method of any of the previous clauses, wherein determining the one or more structures comprises reconstructing a depth profile of the sample surface based on a determined phase and/or amplitude of an electron waveform of reflected and diffracted electrons.
Clause 53. The method of any of the previous clauses, wherein determining the one or more structures comprises identifying defects in a depth profile of the sample surface.
Clause 54. The method of any of the previous clauses, wherein the one or more processors are further configured to detect nanoscale electric fields associated with the sample surface based on variation in diffraction patterns caused by changes in a propagation velocity of electrons under an influence of the nanoscale electric fields, which enables electrical characterization of semiconductor structures.
Clause 55. The method of any of the previous clauses, wherein determining the diffraction pattern for the area of the sample surface; aggregating the diffraction pattern with one or more of the series of diffraction patterns; and determining the one or more structures on the sample surface based on the aggregating comprises lensless imaging.
Clause 56. The method of any of the previous clauses, wherein the one or more processors comprise and/or are configured to execute an algorithm for reconstructing diffraction patterns obtained for different areas of the sample surface into an image.
Clause 57. The method of any of the previous clauses, wherein determining the one or more structures on the sample surface based on the aggregating comprises retrieving, by specific ptychographic signal processing, an amplitude and phase of an associated coherent particle wavefront, from which the one or more structures are determined.
Clause 58. The method of any of the previous clauses, further comprising causing, with an energy reducer, the particle beam to have the beam energy by reducing an initial energy of an initial particle beam from the particle beam generator to the beam energy; wherein the particle beam has a reduced depth of interaction with the sample surface compared to that of the initial particle beam with the initial beam energy.
Clause 59. The method of any of the previous clauses, wherein determining the diffraction pattern comprises measuring the diffraction pattern by the detector and/or the one or more processors.
Clause 60. The method of any of the previous clauses, wherein the particle beam generator, the detector, and the one or more processors comprise a modified scanning electron microscope (SEM),
the modified SEM having a low landing energy, a relatively localized coherent or partially coherent electron probe, projective optics configured to project a diffraction pattern on the detector, an energy filter configured to select elastically scattered electrons, and a pixelated detector configured to record a diffraction image.
Clause 61. A tangible, non-transitory, machine-readable medium storing instructions that when executed by a data processing apparatus cause the data processing apparatus to execute and/or control one or more operations of the method of any of the previous clauses.

Embodiments are described in detail with reference to the drawings, which are provided as illustrative examples of the disclosure so as to enable those skilled in the art to practice the disclosure. Notably, the figures and examples are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

In addition, the combination and sub-combinations of disclosed elements may comprise separate embodiments. For example, one or more of the operations described above may be included in separate embodiments, or they may be included together in the same embodiment.

The descriptions above are intended to be illustrative, not limiting. Thus, it will be apparent to one skilled in the art that modifications may be made as described without departing from the scope of the claims set out below.

## Claims

1. A metrology system, comprising:
a particle beam generator configured to generate a coherent or partially coherent particle beam having a beam energy and beam size;
a detector configured to detect intensity information from reflected and diffracted particle beams and their associated wavefronts from a sample surface, for a reflected diffraction pattern; wherein the reflected and diffracted particle beams result from reflection and diffraction of the particle beam by the sample surface, the beam energy configured such that the particle beam is reflected and diffracted before direct interaction with the sample surface; and
one or more processors configured by machine-readable instructions to:
determine the diffraction pattern for an area of the sample surface corresponding to the beam size based on detected reflected and diffracted particle beams;
aggregate the diffraction pattern with one or more of a series of diffraction patterns corresponding to different areas of the sample surface; and
determine one or more structures on the sample surface based on the aggregating.

2. The system of claim 1, wherein diffraction patterns in the series of diffractions patterns are each associated with a given particle beam position, and wherein particle beams centered at neighboring positions are partially overlapping.

3. The system of claim 1, wherein the particle beam generator, the detector, and the one or more processors comprise a low-energy-electron diffractometer which is configured for measuring electron diffraction patterns.

4. The system of claim 1, wherein the particle beam is:
an electron beam and particles are electrons;
a proton beam and the particles are protons; or
a helium (He) beam, and the particles are He-ions.

5. The system of claim 1, wherein the reflected and diffracted particle beams comprise a particle wavefront, being an electron wavefront, or a proton wavefront, or an He-ion wavefront.

6. The system of claim 1, wherein the particle beam generator comprises a scanner configured such that the sample surface is scanned with the particle beam through different probing particle beam positions to generate the series of diffraction patterns, which are sequential in time, and correspond to different but neighboring areas of the sample surface; and wherein scanning is performed either with a sample stage or with electron-optical deflectors of the metrology system.

7. The system of claim 1, wherein determining the diffraction pattern for the area of the sample surface; aggregating the diffraction pattern with one or more of the series of diffraction patterns; and determining the one or more structures on the sample surface based on the aggregating comprise ptychography operations.

8. The system of claim 1, wherein the diffraction pattern and the one or more of the series of diffraction patterns are far field, or Fraunhofer, diffraction patterns.

9. The system of any of claims 1-8, wherein the one or more processors are further configured to determine phase(s) and/or amplitude(s) of a particle wavefront that is associated with reflected and diffracted particle beams from the sample surface based on the diffraction pattern with the one or more of the series of diffraction patterns, and determine the one or more structures on the sample surface at least partially based on determined phase(s) and/or amplitude(s).

10. The system of claim 1, further comprising a magnetic prism configured to change a direction of the particle beam toward the sample surface and change an opposite direction of reflected electrons towards the detector, one or more deflectors configured to be used to select sample surface locations from which diffraction patterns are obtained, and/or an aperture and/or lens configured to be used to adjust a particle beam diameter.

11. The system of claim 1, wherein the particle beam is a coherent electron beam or a partially coherent electron beam.

12. The system of claim 1, further comprising an energy reducer configured to cause the particle beam to have the beam energy by reducing an initial energy of an initial particle beam from the particle beam generator to the beam energy; wherein reducing the beam energy causes the particle beam to be reflected and diffracted by electric and/or magnetic fields at the sample surface, before direct interaction with the sample surface.

13. The system of claim 1, wherein the particle beam is elastically scattered by the sample surface.

14. The system of claim 1, wherein the detector is a pixelated particle detector at a given distance from the sample surface, the given distance based on a target detection numerical aperture (NA) and an associated resolution.

15. The system of claim 1, wherein determining the one or more structures comprises reconstructing a depth profile of the sample surface based on a determined phase and/or amplitude of an electron waveform of reflected and diffracted electrons.
